# EUROPEAN PATENT APPLICATION

(11) **EP 2 535 939 A1**
(43) Date of publication of application: **19.12.2012**
(21) Application number: 11169735.5
(22) Date of filing: 14.06.2011
(51) Int. Cl.: H01L 29/786

(54) **Thin film transistor**

(71) Applicant: Nederlandse Organisatie voor Toegepast -Natuurwetenschappelijk Onderzoek TNO, 2628 VK Delft (NL); IMEC vzw, 3001 Leuven-Heverlee (BE)
(72) Inventor: Smits, Edsger, 2628 VK Delft (NL); Schoo, Harmannus Franciscus Maria, 2628 VK Delft (NL); Tripathi, Ahutosch, 2628 VK Delft (NL); Gelinck, Gerwin Hermanus, 2628 VK Delft (NL); van der Putten, Bas, 2628 VK Delft (NL)
(74) Representative: Jansen, Cornelis Marinus

(57) **Abstract**

In one aspect, the present invention relates to a method of manufacturing of a thin film transistor, comprising: forming an oxide semiconductor channel layer of thickness less than 20nm on a substrate; forming source and drain electrodes at opposing sides of the channel layer; and applying an oxidizing agent to the channel layer. In another aspect, the present invention relates to a method of manufacturing a thin film transistor, comprising: forming an oxide semiconductor channel layer on a substrate; forming source and drain electrodes at opposing sides of the channel layer; applying an oxidizing agent to the channel layer; and forming a self-assembled monolayer (SAM) on the channel layer, wherein the SAM comprises an unreactive chain having an end group that is non-oxidizing with respect to the oxidizing semiconductor.

## Description

The present invention relates to the manufacture of a thin film transistor having an oxide semiconductor channel layer.

For (metal) oxide thin film transistors, an important parameter is the threshold voltage i.e. the gate voltage at which the device switches on. The threshold voltage is sensitive to defects in the oxide semiconductor channel layer caused by under oxidation during manufacture. Such under oxidation (deficiency of oxygen) in the oxide semiconductor channel layer leaves an excess of free positive charge carriers in the channel layer which results in a current leakage in the off-state and a high negative threshold voltage.

One conventional approach for suppressing this effect is to perform, during manufacture, an annealing step at high temperature (typically 400°C) under an oxygen atmosphere (in air) to allow oxygen to diffuse and neutralize the excess positive charge carriers in the channel layer. However, this approach suffers from the drawback that it requires a minimum temperature of approximately to 250°C to function which is not compatible with low cost substrates, for example, foils made from PEN (polyethylene naphthalate) or PET (polyethylene terephthalate).

US7767505 discloses the manufacture of a thin film transistor having an oxide semiconductor channel layer in which, during manufacture, a nitrous oxide plasma process is used to supply oxygen ions to the surface of the channel layer, and then an annealing step activates the supplied oxygen ions so as to form oxygen bonds within the channel layer, thereby reducing the excess of free positive charge carriers. This approach is disadvantageous as it requires using expensive plasma equipment and hazardous nitrous oxide gas.

US2009/0140243 discloses the manufacture of a thin film transistor having an oxide semiconductor channel layer in which, during manufacture, the carrier density of a surface of the channel layer is controlled by an oxidization treatment using an oxidizing agent. Three methods are disclosed. According to a first method, a liquid oxidizing agent is placed in contact with the surface of the channel layer. The liquid oxidizing agent may include permanganate, perchlorate and peroxide compounds. According to a second method, the oxidization treatment includes forming a SAM (self-assembled monolayer), that includes an oxidizing agent, on the surface of the channel layer. The SAM may be a phosphonic acid group containing SAM. According to a third method, as an alternative the first or second methods, a passivation layer formed of an organic insulating material and including a functional group that is capable of oxidizing the channel layer is used. It may be necessary to anneal the passivation layer.

According to a first aspect, the present invention may provide a method of manufacturing of a thin film transistor, comprising:
forming an oxide semiconductor channel layer of thickness less than 20nm on a substrate;
forming source and drain electrodes at opposing sides of the channel layer; and
applying an oxidizing agent to the channel layer.

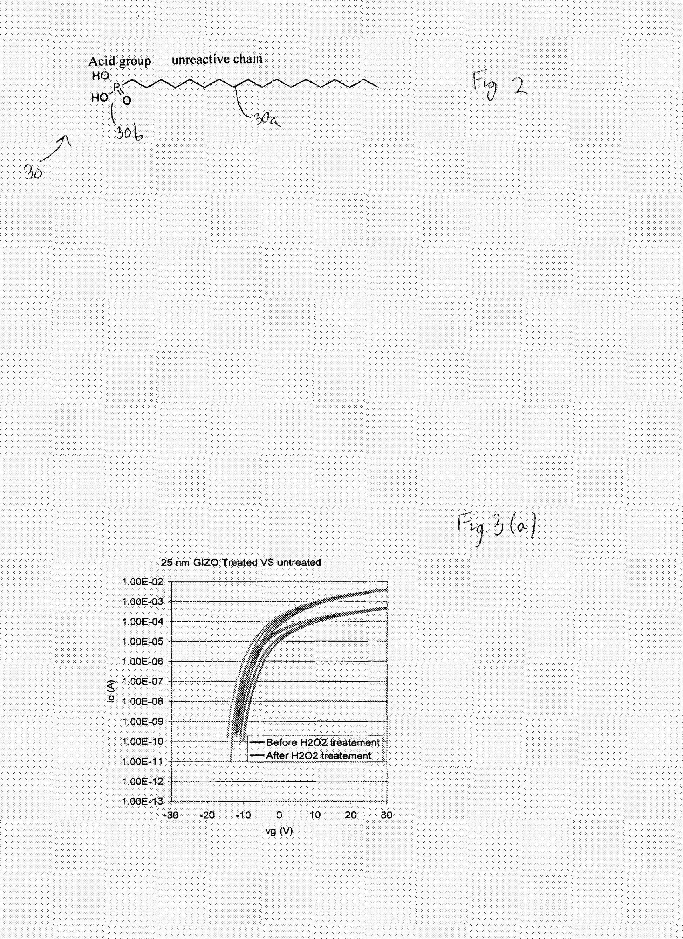

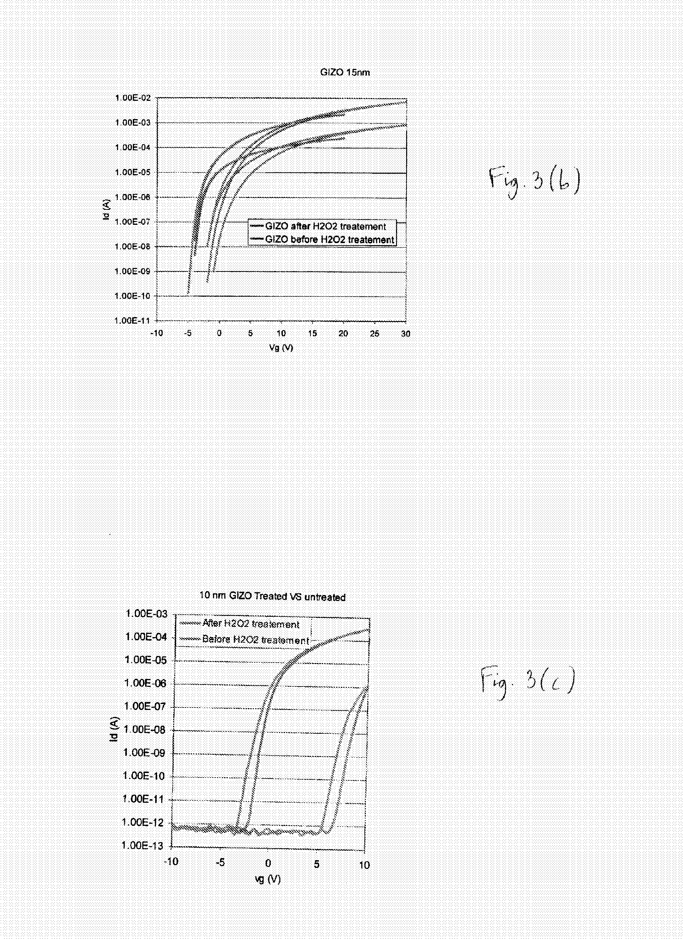

A typical prior art thin film transistor has a channel layer with a thickness of 50-60nm (nanometers). The applicant has found that by limiting the thickness of the channel layer, a thin film transistor manufactured according to the first aspect of the present invention may have a much reduced negative or even positive threshold voltage. Although the mechanism is not presently understood, the effect becomes appreciable when the channel layer has a thickness of less than around 20nm and progressively more pronounced as the channel layer becomes thinner as is illustrated in Figures 3(a-c). Preferably, the thickness of the channel layer is less than around 15nm, more preferably less than around 12nm, and most preferably less than around 10nm.

The channel layer may be originally deposited at the required thickness. Alternatively, the channel layer may be deposited at a thickness greater than required and etched down to the required thickness.

In a preferred embodiment, the oxidizing agent is liquid. A preferred oxidizing agent is hydrogen peroxide. The hydrogen peroxide is preferably in neutral form i.e. not in combination with an acid or a catalyst. The applying step may comprise submerging the channel layer in a preferably 25-35%, less preferably 15-45%, hydrogen peroxide solution in water. The applying step results in a semiconductor layer having a predetermined threshold voltage.

Preferably, the method further comprises forming a self-assembled monolayer (SAM) on the channel layer, wherein the SAM comprises an unreactive chain having an end group that is non-oxidizing with respect to the oxide semiconductor. The end group may be an acid group which undergoes an acid-oxide reaction with the surface of the channel layer. By applying the SAM, the transistor is stabilized, whereby the threshold voltage may be maintained at the predetermined level.

In a preferred embodiment, the SAM comprises an unreactive alkane octadecyl chain having a phosphonic acid end group. Alternatively, carboxylic, sulphonic, or silane may be used as the end group. Linear or branched alkane molecules or aromatic compounds may be used as part of the unreactive chain. None of these molecules have oxidizing properties with respect to the oxide semiconductor.

According to a second aspect, the present invention may provide a thin film transistor, comprising:
an oxide semiconductor channel layer on a substrate;
source and drain electrodes at opposing sides of the channel layer;
wherein the channel layer has a thickness of less than 20nm.

According to a third aspect, the present invention may provide a method of manufacturing a thin film transistor, comprising:
forming an oxide semiconductor channel layer on a substrate;
forming source and drain electrodes at opposing sides of the channel layer;
applying an oxidizing agent to the channel layer; and
forming a self-assembled monolayer (SAM) on the channel layer, wherein the SAM comprises an unreactive chain having an end group that is non-oxidizing with respect to the oxide semiconductor.

Using a SAM comprising an unreactive chain having an end group that is non-oxidizing with respect to the oxide semiconductor to stabilize the already-oxidized channel layer is not taught by the prior art. In particular, the above-mentioned US2009/0140243 discloses using a SAM that specifically includes a functional group to perform the oxidization of the channel layer.

The end group may be an acid group which undergoes an acid-oxide reaction with the surface of the channel layer. In a preferred embodiment, the SAM comprises an unreactive alkane octadecyl chain having a phosphonic acid end group. Alternatively, carboxylic, sulphonic, or silane may be used as the end group. Linear or branched alkane molecules or aromatic compounds may be used as the unreactive chain. None of these molecules have oxidizing properties with respect to the oxide semiconductor.

The third aspect of the present invention may be used independently of the first aspect of the present invention.

According to a fourth aspect, the present invention may provide a thin film transistor, comprising:
an oxide semiconductor channel layer on a substrate;
source and drain electrodes at opposing sides of the channel layer; and
a self-assembled monolayer (SAM) on the channel layer, wherein the SAM comprises an unreactive chain having an end group that is non-oxidizing with respect to the oxide semiconductor..

Throughout the specification, "or" is used in a non mutually exclusive sense.

Exemplary embodiments of the present invention are hereinafter described with reference to the accompanying drawings, in which:
Figures 1(a-e) illustrate the manufacture of a thin film transistor (TFT) of the bottom contact type;
Figure 2 shows a SAM in accordance with a preferred embodiment of the invention; and
Figures 3(a-c) illustrate how in a TFT the threshold voltage is shifted through oxidization treatment by hydrogen peroxide for various thicknesses of channel layer.

Throughout this description the same or corresponding parts have been given the same or corresponding reference numerals.

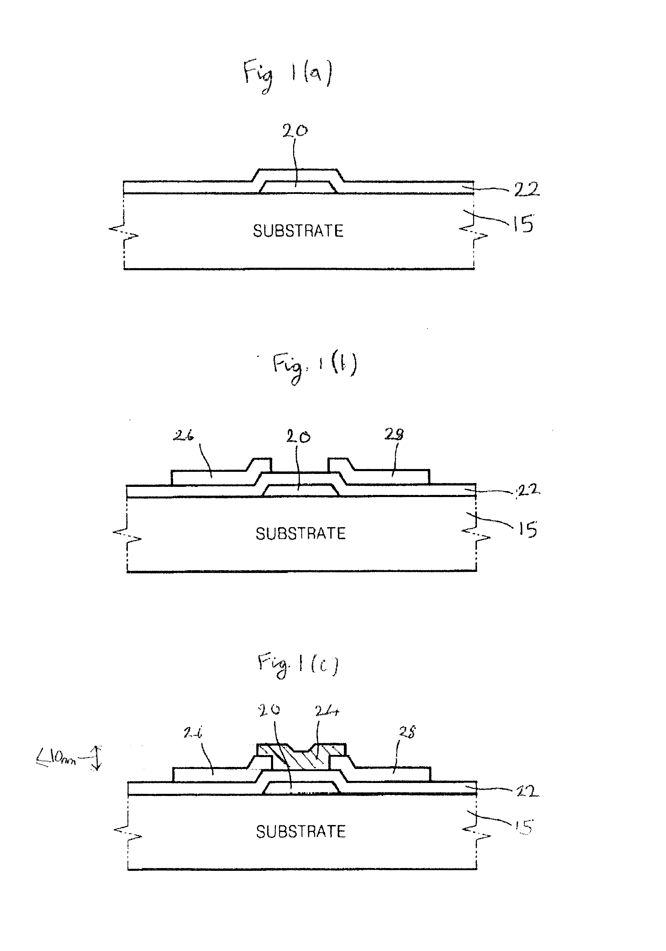

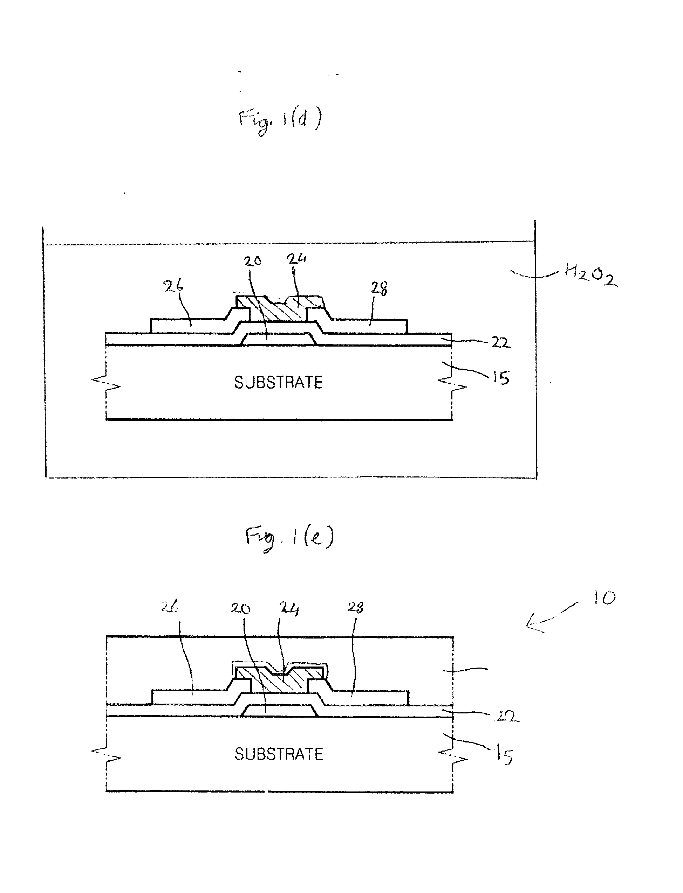

Figures 1(a-e) illustrate the manufacture of a thin film transistor (TFT) of the bottom contact type, which is generally designated 10.

Referring to Figure 1(a), a gate 20 is formed on a substrate 15. The substrate 15 preferably comprises a PEN or PET foil. A gate insulating layer 22 that covers the gate 20 is formed on the substrate 15. The gate insulating layer 22 may be a SiOx (e.g., SiO2) or SiNx layer. After forming the gate insulating layer 22, a wet washing process is optionally performed to eliminate (or remove) impurities on a top surface of the gate insulating layer 22. During the wet washing process, at least one of isopropyl (IPA), deionized water, acetone or the like may be used as a washing solution.

Referring to Figure 1(b), a conductive material layer (not shown) is formed on the gate insulating layer 22. The conductive material layer may be patterned to form a source electrode 26 and a drain electrode 28. A general dry, or wet method may be used for patterning the source electrode 26 and the drain electrode 28. In the case of a wet method, an etchant having phosphoric acid, nitric acid, acetic acid or the like as a main (or primary) component may be used. The patterned conductive material layer, or the electrodes 26, 28, obtained may be made of one of a molybdenum (Mo) single metal layer, a multi-metal layer including a molybdenum (Mo) layer, a metal layer including titanium (Ti), and a metal layer including chromium (Cr). The conductive material layer, or the electrodes 26,28, may be formed of a conductive material including at least one of Mo, Ti, Pt, Cu, Al, W, MoW, AlNd, Ni, Ag, Au, IZO, ITO and combinations thereof. The conductive material layer or the electrodes 26,28 may be formed of a silicide including at least one of Mo, Ti, Pt, Cu, Al, W, MoW, AlNd, Ni, Ag, Au, IZO, ITO and combinations thereof. The conductive material, or the silicide, used to form the conductive material layer, or the electrodes 26,28 may include at least one of Cu, Mo, Al and combinations thereof. The conductive material layer may be formed using a physical vapour deposition (PVD) method.

Referring to Figure 1(c), a channel layer 24 corresponding to the gate 20 is formed on the gate insulating layer 22 between the source electrode 26 and the drain electrode 28. The channel layer 24 may be formed using a PVD method including general sputtering and evaporation methods.

In a preferred embodiment, the channel layers 24 is made of a ZnO based material, for example, amorphous Ga-In-Zn-O (GIZO). GIZO may be formed of a(In2O3).b(Ga2O3).c(ZnO) where a, b and c are actual numbers respectively satisfying the following expression: a>=0, b>=0 and c>0. GIZO may be formed of a(In2O3).b(Ga2O3).c(ZnO) where a, b and c are numbers respectively satisfying the following expressions: a>=1, b>=1, and 0<c<=1. In other embodiments, other semiconductor material systems may be used.

The channel layer 24 is formed with a thickness of 10nm or less. In less preferred embodiments, the channel layer 24 is formed with a thickness of from 10nm to 20nm.

Since the channel layer 24 is particularly sensitive to defects caused by under oxidation during its manufacture, an oxidation treatment using an oxidizing agent is performed as illustrated in Figure 1(d). In a preferred embodiment, that treatment comprises submersing the wafer in 30% hydrogen peroxide solution for 10-15 minutes at 70°C. The hydrogen peroxide solution is in normal form i.e. an acid or a catalyst is not present. This treatment results in a (slightly) p-doped surface/semiconductor having a predetermined threshold voltage.

In other embodiments, other oxidizing agents may be used. But hydrogen peroxide is preferred due to its availability and low toxicity.

Referring to Figure 1(e), in order to stabilize the oxidized surface, whereby the predetermined threshold voltage is maintained, a self-assembled monolayer (SAM) 30 is formed on the channel layer. In a preferred embodiment, an octadecyl phosphonic acid SAM is used. As shown in Figure 2, the SAM 30 more generally comprises an unreactive chain 30a having an end group 30b that is non-oxidizing with respect to the oxide semiconductor material (but could be oxidizing with respect to other materials); for example, the end group 30b may be an acid group which undergoes an acid-oxide reaction with the oxidized surface of the channel layer 24 and in so doing becomes grafted thereto. Other SAMs may be used.

Referring still to Figure 1(e), a passivation layer 32 is optionally formed on the SAM 30, the source and drain electrodes 26,28 and the insulating layer 22 by using a known deposition method. The passivation layer 24 may be formed of SiNₓ or SiOₓ.

Figure 3(a-c) show how the threshold voltage of transistors manufactured according to the above-described preferred embodiment varies according to the thickness of the channel layer. As can be seen from Figure 3(a), a transistor having a channel layer with a 10nm thickness shifts from a switch-on of -2V to +7V. As can be seen from Figure 3(b), a transistor having a channel layer with a 15nm thickness shifts from a switch-on of -5 V to approximately 0V. For transistors having a channel layer with a thickness greater than 20nm, the shift in switch-on voltage is much less pronounced. For example, as can be seen in Figure 3(c), at 25nm only a slight shift from -12V to -10V can be achieved.

In other embodiments, the transistor may have a different architecture, for example, it may be a top contact type transistor.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features. In view of the foregoing description it will be evident to a person skilled in the art that various modifications may be made within the scope of the invention.

### List of parts

- Transistor: 10
- Substrate: 15
- Gate: 20
- Insulating layer: 22
- Channel layer: 24
- Source electrode: 26
- Drain electrode: 28
- SAM: 30
- Unreactive chain: 30a
- Non-oxidizing end group: 30b
- Passivation layer: 32

## Claims

1. A method of manufacturing of a thin film transistor, comprising:
forming an oxide semiconductor channel layer of thickness less than 20nm on a substrate;
forming source and drain electrodes at opposing sides of the channel layer; and
applying an oxidizing agent to the channel layer.

2. A method as in claim 1, wherein the thickness of the channel layer is less than 15nm, preferably less than 12nm, and most preferably less than 10nm.

3. A method as in any preceding claim, wherein the oxidizing agent is liquid hydrogen peroxide in normal form.

4. A method as in any preceding claim, further comprising forming a self-assembled monolayer (SAM) on the channel layer, wherein the SAM comprises an unreactive chain having an end group that is non-oxidizing with respect to the oxide semiconductor.

5. A method of manufacturing a thin film transistor, comprising:
forming an oxide semiconductor channel layer on a substrate;
forming source and drain electrodes at opposing sides of the channel layer;
applying an oxidizing agent to the channel layer; and
forming a self-assembled monolayer (SAM) on the channel layer, wherein the SAM comprises an unreactive chain having an end group that is non-oxidizing with respect to the oxide semiconductor.

6. A method as in claims 4 or 5, wherein the end group is an acid group which undergoes an acid-oxide reaction with the surface of the channel layer.

7. A method as in claim 6, wherein the SAM comprises one of an alkane octadecyl chain, linear alkane molecules, branched alkane molecules, or aromatic compounds as the unreactive chain.

8. A method as in claim 7, wherein the SAM comprises one of a phosphonic, carboxylic, sulphonic or silane acid as the end group.

9. A thin film transistor, comprising:
an oxide semiconductor channel layer on a substrate;
source and drain electrodes at opposing sides of the channel layer;
wherein the channel layer has a thickness of less than 20nm.

10. A thin film transistor, comprising:
an oxide semiconductor channel layer on a substrate;
source and drain electrodes at opposing sides of the channel layer; and
a self-assembled monolayer (SAM) on the channel layer, wherein the SAM comprises an unreactive chain having an end group that is non-oxidizing with respect to the oxide semiconductor.
